(19) Europäisches Patentamt
European Patent Office
Office européen des brevets

(11) EP 2 288 031 A1

(12) EUROPEAN PATENT APPLICATION

(43) Date of publication:
23.02.2011 Bulletin 2011/08

(51) Int Cl.:
H03K 23/68 (2006.01)    G06F 7/62 (2006.01)

(21) Application number: 09251896.8

(22) Date of filing: 28.07.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(71) Applicant: NXP B.V.
5656 AG Eindhoven (NL)

(72) Inventors:
• Wel, Arnoud van der
Redhill
Surrey RH1 1DL (GB)

• Besten, Gerrit Willem den
Redhill
Surrey RH1 1DL (GB)
• Janssen, Erwin
Redhill
Surrey RH1 1DL (GB)

(74) Representative: Williamson, Paul Lewis
NXP Semiconductors
IP Department
Betchworth House
57-65 Station Road
Redhill
Surrey RH1 1DL (GB)

(54) **A frequency divider**

(57) A frequency divider (200; 300; 400) configured to receive a plurality of oscillating signals (202; 302; 402) and generate output signalling (204; 310; 410). The frequency divider comprises an enable signalling generator (206) configured to process the plurality of oscillating signals (202; 302; 402) and generate enable signalling (210; 314) representative of which of the oscillating signals (202; 302; 402) is to be used to derive the output signalling (204; 310; 410). The frequency divider also comprises an output signal selector (208; 308; 408) configured to process one or more of the oscillating signals (202; 302; 402) and the enable signalling (210; 314) such that an oscillating signal (202; 302; 402) is provided as the output signalling (204; 310; 410) of the frequency divider in accordance with the enable signalling (210; 314).

## Figure 2

**Description**

The present disclosure relates to the field of frequency dividers, devices comprising frequency dividers and methods of operating frequency dividers.

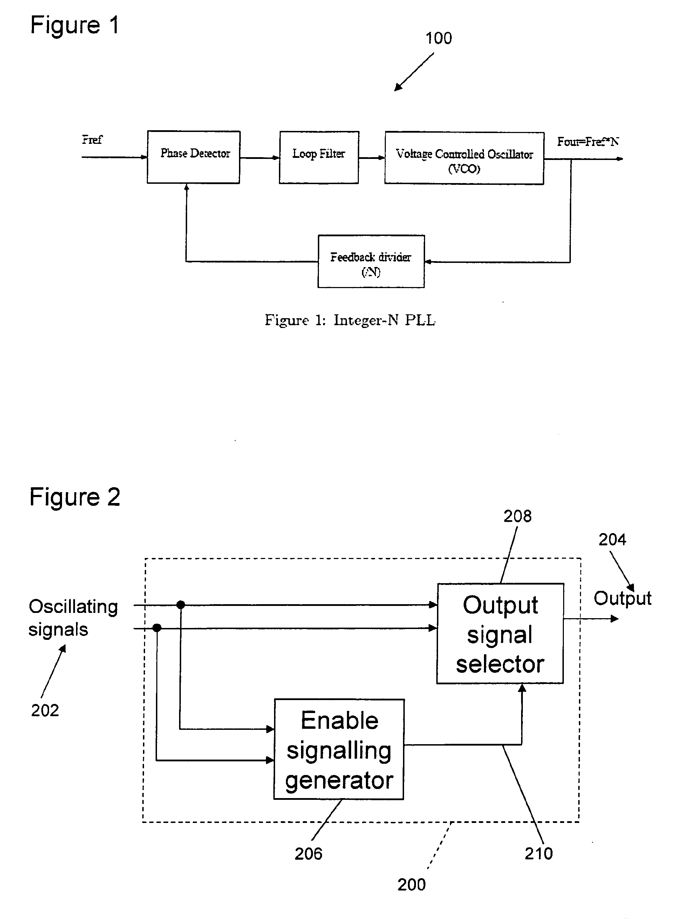

Frequency dividers are known to be used as part of a phase locked loop (PLL), which is a building block commonly used for frequency multiplication. An example of a known phase locked loop is illustrated in Figure 1.

Known phase locked loops work by comparing a (low frequency) reference frequency signal with a divided version of the (high frequency) output signal of a controlled oscillator. The PLL produces an output frequency that is an exact multiple of the input frequency.

In some examples it is desirable for the output frequency to be a non-integer multiple of the input frequency, which may be known as fractional-N PLL.

Two known methods for providing a fractional-N PLL are:

1) To divide the reference frequency by a first integer "R" before providing the frequency divided signal to an integer-N PLL that multiplies by an integer factor of "N". The effective frequency multiplication ratio of the PLL is now N/R, which need not necessarily be an integer.

2) To alternately divide by two or more different ratios, for example by N and by (N+1) such that the time averaged multiplication/division ratio can be a non-integer value between the values "N" and "N+1". By adding a sigma-delta loop that controls the divider ratio, the average division ratio can be adjusted.

A disadvantage associated with method 1) above is that the effective reference frequency of the PLL is now lower by a factor of R. This means that the bandwidth of the PLL will be lower by the same factor, which may be undesirable. Furthermore, the components in the PLL loop filter will also become physically larger.

A disadvantage associated with method 2) above is that the output spectrum can contain spurs at unpredictable frequencies. Such spurs can be caused because the instantaneous frequency multiplication factor of the PLL as a whole is never correct; it is only the time-averaged frequency multiplication factor that is correct. In addition, the complexity of such a PLL may be considerable.

US 2002/0027459 (Fallahi et al) discloses frequency division/multiplication with jitter minimization. This document discloses increasing the number of available clock phases to M and then shifting the output clock phase by one, every K/M cycle. This can be accomplished by adding a multiplexer (MUX) to the output of the PLL.

US 6,526,374 (Agere Systems Inc.) discloses a fractional PLL embodying a phase-selection feedback counter.

US 6,542,013 (Intel Corporation) discloses fractional divisors for multi-phase PLL systems. A phase-shifting circuit is coupled to a PLL to select one of the phase signals generated by the oscillator according to a defined phase sequence to be passed to the feedback loop.

The listing or discussion of a prior-published document or any background in the specification should not necessarily be taken as an acknowledgement that the document or background is part of the state of the art or is common general knowledge.

According to a first aspect of the invention, there is provided a frequency divider configured to receive a plurality of oscillating signals and generate output signalling, the frequency divider comprising:

an enable signalling generator configured to process the plurality of oscillating signals and generate enable signalling representative of which of the oscillating signals is to be used to derive the output signalling;
an output signal selector configured to process one or more of the oscillating signals and the enable signalling such that an oscillating signal is provided as the output signalling of the frequency divider in accordance with the enable signalling.

In this way the output of the frequency divider can be generated from the oscillating signals with a reduced/minimal amount of processing when compared with the prior art. This can reduce any propagation delays in performing the frequency division and can also reduce or minimise jitter in the output signalling. Jitter is an unwanted variation in the timing of the output signal. The presence of spurs in the frequency spectrum of the output signal, for example, is indicative of jitter in the output signal.

The prior art may be considered as performing phase/oscillating signal selection (for example with a multiplexer) before frequency division, whereas embodiments of the invention may perform frequency division before phase/oscillating signal selection. In this way, the processing performed on the original oscillating signal before being passed to the output of the frequency divider can be reduced and therefore propagation delays can also be reduced.

One or more embodiments described herein may avoid the need for a multiplexer that performs phase/oscillating signal selection before frequency division.

The enable signalling may be representative of which of the oscillating signals is to be used to derive the output signalling at a given time. The enable signalling may be set at an instant in time so that the next occurrence of a rising edge (or any other part of the waveform) in the associated oscillating signal is provided as the output signalling in order to provide the desired frequency multiplication/division.

The oscillating signals may be sinusoidal signals, square waves, or may be any other types of signal that have a frequency that is to be converted by the frequency divider. The oscillating signals may be outputs of a voltage controlled oscillator with different phases. An example of such a voltage controlled oscillator is a ring oscillator.

One or more embodiments may be considered as providing simultaneous/parallel processing of a plurality of phase/oscillating signals in order to enable the output signalling to be more quickly set/provided.

The oscillating signal that is to be used to derive the output signalling may comprise a rising edge that is to be a rising edge in the output signalling. The enable signalling may be configured to cause the output signal selector to set the oscillating signal as the output signalling at a point in time before the rising edge of the oscillating signal. In this way, any propagation delays caused by providing the oscillating signal as the output signalling may be reduced and/or minimised or may be considered as inconsequential. This may be because the output signal selector is preset by the enable signalling to pass the appropriate oscillating signal to the output signalling before the desired portion of the oscillating signal is received by the output signalling selector.

The point in time at which the enable signalling is set may be after a previous rising edge of the oscillating signal. The point in time may be after a preceding trailing edge of the oscillating signal. In this way, the enable signalling may cause the input oscillating signal to be provided as the output signalling at an instant time at which the input oscillating signal is zero and therefore does not change the value of the output signalling until the next rising edge of the oscillating signal.

The enable signalling generator may be configured to set the enable signalling before the occurrence of the portion of the corresponding oscillating input signal that is to be provided as the output signalling, but after a preceding portion of the oscillating signal that is not to be provided as the output signalling. Setting a signal may comprise providing a rising edge or a trailing edge of the signal waveform.

The portion of the corresponding oscillating input signal that is to be provided as the output signalling may begin with a rising edge of the oscillating signal, and may end with a trailing edge. The portion of the corresponding oscillating input signal that is to be provided as the output signalling may comprise a non-zero pulse.

The enable signalling generator may comprise a counter configured to process one or more of the plurality of oscillating signals and generate one or more counter output signals representative of when one or more of the plurality of oscillating signals reaches a predetermined count value. The enable signalling generator may be further configured to derive the enable signalling from the one or more counter output signals.

In some embodiments of the invention a plurality of counters may be provided that count different oscillating signals in order to provide the enable signalling.

The modulus of the counter may be selected in order to provide a desired frequency division factor. The modulus of the counter may be selected in accordance with the equation:

$$M = LCM(K, n)/n;$$

where M is the modulus of the counter, (K/n) is the non-integer frequency division factor, and LCM represents a lowest common multiple operation.

The counter may be a programmable counter. In this way, the counter can be reprogrammed to provide different frequency division/multiplication factors as required.

The enable signalling may comprise one or more of the counter output signals. That is, for some frequency division factors a counter output signal may be of the required format to provide enable signalling for the output signalling selector. Whether or not a counter output signal may be considered as appropriate for direct presentation as the enable signalling may depend upon the specific frequency division factor that is required and/or the number of oscillating signals that are provided to the counter.

The enable signalling generator may further comprise a pre-alignment block of components comprising one or more delay components configured to apply a time delay to one or more of the counter output signals in accordance with one or more of the oscillating signals in order to generate the enable signalling. The one or more delay components may comprise delay flip-flops. One of the counter output signals may be provided as a D input of the flip flop, and one of the oscillating signals may be provided as a clock input of the flip flop.

The pre-alignment block of components can set the enable signalling at a predetermined/desired time relative to the oscillating signal to which the enable signalling relates. The enable signalling may be set at a time at which the corresponding oscillating signal is zero.

The output signal selector may comprise one or more logic gates that are configured to pass an input oscillating signal to the output signalling when the enable signalling associated with the input oscillating signal is set.

There may be provided a phase locked loop comprising any frequency divider disclosed herein. The phase locked loop may comprise an oscillator configured to generate the plurality of input oscillating signals.

There may be provided a device comprising any frequency divider disclosed herein or any phase locked loop disclosed herein. Some typical examples of devices that may use a PLL containing a frequency divider as disclosed herein are: serial data transmitters and receivers, such as those used in wired communication (such as USB, SATA, PCI-express) and wireless communication (such as WLANWFi, Bluetooth, GPRS, UMTS, GSM, UltraVVideBand).

According to a further aspect of the invention, there is provided a method of operating a frequency divider comprising:

> receiving a plurality of oscillating signals;
> processing the plurality of oscillating signals to generate enable signalling representative of which of the oscillating signals is to be used to derive the output signalling; and
> processing one or more of the oscillating signals and the enable signalling such that an oscillating signal is provided as the output signalling of the frequency divider in accordance with the enable signalling.

According to a further aspect of the invention there is provided a computer program, which when run on a computer, causes the computer to configure any apparatus, including a circuit or a frequency divider, disclosed herein. The computer program may be a software implementation, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

The computer program may be provided on a computer readable medium such as a disc or a memory device, or may be embodied as a transient signal. Such a transient signal may be a network download, including an internet download.

A description is now given, by way of example only, with reference to the accompanying drawings, in which:

> Figure 1 illustrates a prior art phase locked loop;
> Figure 2 illustrates a frequency divider according to an embodiment of the invention;
> Figure 3 illustrates a frequency divider according to another embodiment of the invention;
> Figure 4 illustrates a frequency divider according to a further embodiment of the invention; and
> Figure 5 illustrates a timing diagram illustrative of the operation of the frequency divider of Figure 4.

One or more embodiments disclosed herein can provide a frequency divider for applying non-integer frequency division factors. The frequency divider may process one or more oscillating signals (for example phase shifted output signals of a voltage controlled oscillator) in order to generate "enable signalling° representative of which of the oscillating signals is to be used to derive the output signalling. The frequency divider may contain an output signalling selector such as logic gating that can use the enable signalling to provide one of the oscillating signals as the appropriate output signalling of the frequency divider for a period of time that is appropriate in order to obtain the desired frequency division factor. For example, the output signalling selector may provide a pulse from any of the oscillating signals as the output signalling at a desired time in order to achieve the desired frequency division factor. It will be appreciated that embodiments of the invention can also provide frequency multiplication by using a frequency division factor of less than one.

Providing a frequency divider in this way can reduce the processing that is performed on the oscillating signals before being provided as an output of the frequency divider when compared with the prior art. For example, only relatively simple gating logic may be provided directly between the input and the output of the frequency divider thereby decreasing the propagation delay in generating the output signal when compared with the prior art.

One or more embodiments of the invention can be considered as performing frequency division processing before the phase/oscillating signal selection, and this is in contrast to the prior art. In this way, any disadvantages in terms of delays and/or jitter can be addressed by some examples of the invention.

Figure 2 illustrates a frequency divider 200 according to an embodiment of the invention. In this example, the frequency divider 200 receives two oscillating signals 202 and generates output signalling 204. The oscillating signals 202 are different phase signals generated by a voltage controlled oscillator (VCO) such as a ring oscillator. However, it will be appreciated that the oscillating signals 202 are not limited by how they are generated.

The oscillating signals 202 are provided to an enable signalling generator component 206. The enable signalling generator 206 can process the oscillating signals 202 in order to generate enable signalling 210. The enable signalling 210 is representative of which, if any, of the oscillating signals 202 should be provided as the output signalling 204 for any instance/period of time. It will be appreciated, and is described below, that none of the oscillating signals 202 may be connected to the output signalling 204 for periods of time in order to achieve output signalling that provides the desired frequency division factor.

The enable signalling 210 is provided to output signal selector block 208 along with the original oscillating signals 202. As can be seen in Figure 2, the oscillating signals 202 are directly provided to the output signal selector block 208 as well as being indirectly provided to the output signal selector block 208 via the enable signalling generator 206. The output signal selector block 208 is configured to operably provide one of the oscillating signals 202 as the output signalling 204 as required. Such provision of the output signalling may be considered as the output signal selector block 208 passing one of the oscillating signals 202 on to an output port/connection of the frequency divider 200.

In this example, the frequency divider 200 is configured to receive two oscillating signals 202, which are phase shifted by 180° with reference to each other. The two oscillating signals 202 have the same frequency as they are generated by the same voltage controlled oscillator. In such embodiments, non-integer division factors of 1.5, 2.5, 3.5, etc. can be achieved. This is because a pulse from one of the oscillating signals 202 can be coupled to the output signalling 204 by the logic 208 either at a point in time when the first oscillating signal 202 has a rising edge or at a point in time when the other oscillating signal 202 has a rising edge. In essence, twice as many rising edges of the oscillating signals 202 are available for the output signalling 204 due to the two oscillating signals 202.

It will be appreciated that a frequency divider 200 that is configured to receive three oscillating signals 202 can provide non-integer division factors of $1^1/_3$, $1^2/_3$, $2^1/_3$, $2^2/_3$, etc. as well as integer division if required. This is because an output pulse can be selected for the output signalling from one of three input oscillating signals 202.

In some embodiments, the enable signalling generator 206 can be considered as a "divider" component and the output signal selector block 208 can be considered as a "phase/signal selection" component. That is, the divider 206 is operable before the phase selection component 208 thereby reducing any delays in generating the output signalling 204 that would be caused by providing the "divider" component directly in the data processing path between the input signalling and the output signalling. This can be in contrast to the prior art where phase selection is performed before frequency division.

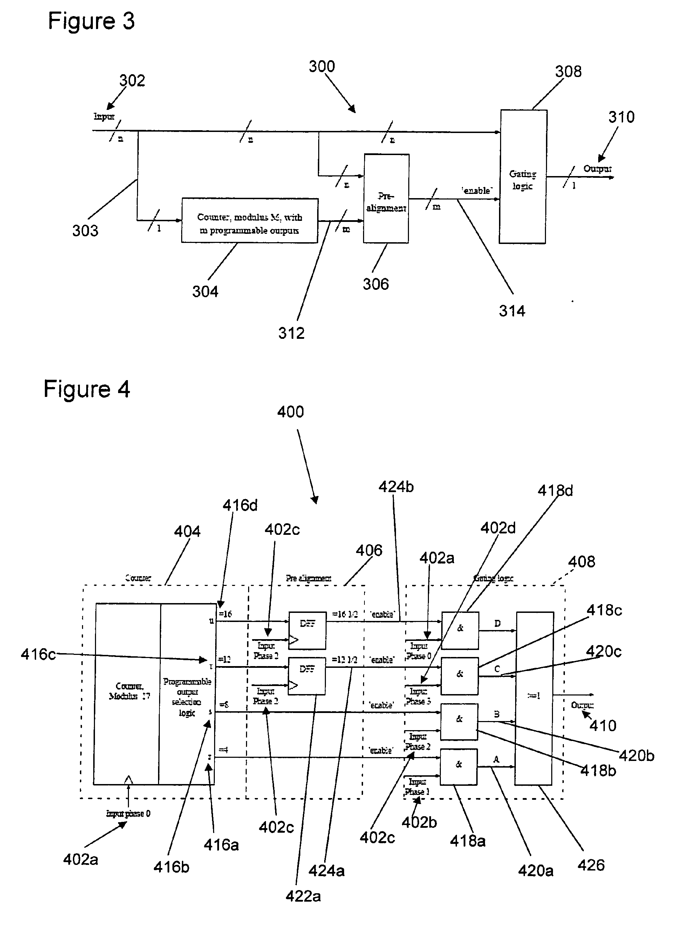

Figure 3 illustrates a further embodiment of a frequency divider 300 according to an embodiment of the invention.

The frequency divider 300 receives n input signals 302 that may be considered as equally spaced "phase signals" or "oscillating signals" from a voltage controlled oscillator. The frequency divider 300 is configured to generate a single output signal 310.

The frequency divider 300 includes a counter 304, a pre-alignment block 306 and gating logic 308. The gating logic is an example of an "output signal selector", and it will be appreciated that other known components can be used to perform the functionality of the output signal selector. For example, the "output signal selector" may comprise one or more multiplexers, and/or standard digital components such as NAD gates, OR gates, NAND gates and NOR gates that can provide an implementation of a multiplexer.

One of the input signals 302, for example the phase signal that is identified as phase zero 303, is provided to the counter 304. The counter is a modulus M counter with m programmable outputs 312 that can be set high when a predetermined value in the count is reached. The m programmable outputs 312 of the counter 304 are provided as inputs to the pre-alignment block 306 along with the n input signals 302.

The pre-alignment block 306 is configured to process the programmable outputs 312 of the counter 312 along with the original phase signals 302 in order to generate m enable signals 314. The pre-alignment block 306 can be used for phase aligning the enable signals 314. In this example, the counter 304 and the pre-alignment block 306 may be considered together as the enable signalling generator illustrated in Figure 2.

Use of the counter 304 and the pre-alignment block 306 in this way can enable a plurality of the input signals 302 to be processed in order to generate enable signalling 314 representative of which, if any, of the original input signals 302 should be passed to the output 310, and at what time.

It will be appreciated that in other embodiments, a plurality of the input signals 302 could be provided as inputs to the counter 304. In such embodiments, input signals 302 may not be required for the pre-alignment block 306. This is because the counter 304 can perform the required processing on a plurality of input signals 302 to generate the required enable signalling 314 in order to provide non-integer frequency division factors.

In further embodiments still, more than one counter may be provided in order to count different input signals 302.

The enable signalling 314 generated by the pre-alignment block 306 are provided as inputs to the gating logic 308. Also provided as an input to the gating logic 308 are the original input phase signals 302. The enable signalling 314 is configured to be set high for a corresponding one of the input signals 302 just before a rising edge of that input signal 302 so that the input phase signal 302 is immediately passed to the output 310 of the gating logic when that input phase signal goes high.

It will be appreciated that "just before" can be at any time between rising edges of that individual input signal 302, or in some embodiments may be at any time after the preceding trailing edge of that specific input signal 302. "Just before" can represent any period of time for which only the desired portion of the input signal 302 is passed to the output 310.

In the architecture of Figure 3, it can be easy and beneficial to arrange the timing of the enable/logic signals 314 so that the timing of the edges of the output signalling 310 is directly determined by the edges of the input signalling 302. Delay and jitter caused by the counter 304 and/or the pre-alignment block 306 may not influence the timing of the output signalling 310 because these components are not directly in the data processing path between the input 302 and the output 310 of the frequency divider. As can be seen in Figure 3, the processing performed by the counter 304 and the pre-alignment block 306 can be considered as being in parallel with the direct data path between the input 302 and the output 310.

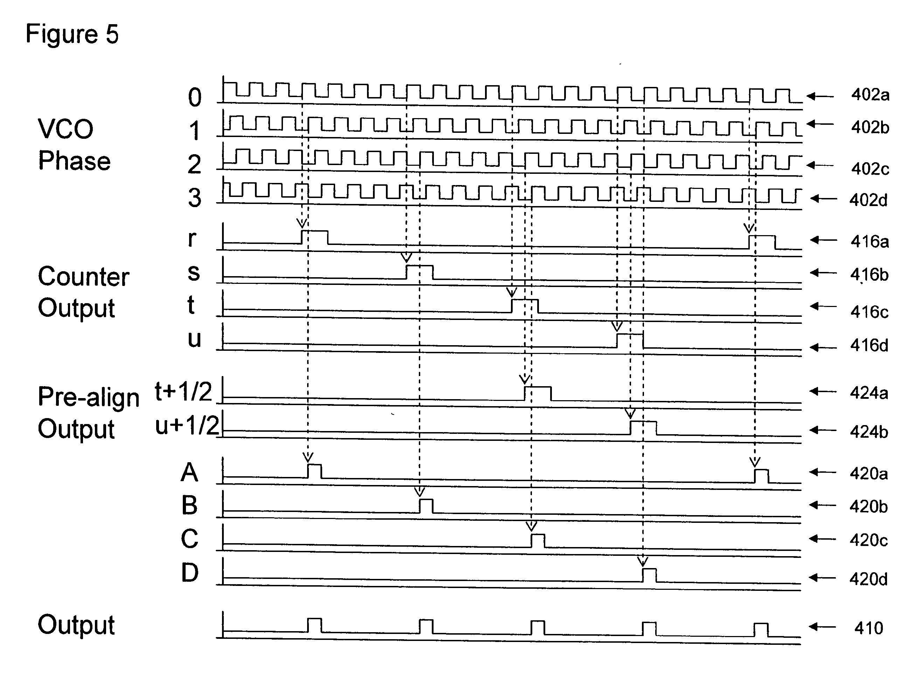

The structure of Figure 3 can produce a frequency division of K/n, where K may be chosen as desired and n is the number of available input phases. The modulus of the counter, M, should then be made equal to the lowest common multiple of K and n, divided by n: that is M=LCM(K,n)/n. This equation will be described in more detail with respect to the specific example illustrated as Figures 4 and 5.

Figure 4 illustrates further detail of an example of a frequency divider 400 according to an embodiment of the invention. The frequency divider 400 of Figure 4 is similar to that of Figure 3, and corresponding features have been given similar reference numbers in the 400 series.

The frequency divider 400 of Figure 4 is implemented to provide a non-integer frequency division factor of 4 ¼. (17/4). That is, the output signal 410 should provide a single output pulse for each 4.25 pulses of the input signalling. It will be recalled that each of the input signals has the same frequency and therefore it does not matter with which of the input signals the output is controlled in relation to.

As discussed above, in order to use equation: M=LCM(K,n)/n, the frequency division should be expressed as K/n. Therefore, in this example n=4 and K=17. M is then calculated using the above equation, and in this example M=17 and a counter 404 with modulus 17 is used.

The output signalling 410 should have rising edges at time instants 4.25, 8.5, 12.75 and 17 periods. Since the desired output events are evenly spaced throughout a single input period, a pre-alignment block 406 is placed between the counter 404 and the gating logic block 408 in order to delay one or more of the counter output events/signals by a fraction of a period. In this example, the counter 404 is driven by a single clock phase. The pre-alignment block 406 may be required because a counter 404 that is driven by a single clock phase cannot directly provide suitable 'enable' signalling for the gating logic 408 as will be described below.

The timing of the whole system can be controlled so that the 'enable' outputs of the pre-alignment block 406 will always be active before a rising edge of the corresponding input phase signal 402 that is to be passed to the output signalling 410. In this way, the input phase signals 402 can be used to directly determine the timing of the edges of the output signalling, and delay and jitter caused by the counter and the pre-alignment block may not propagate though the system, or at least may be reduced when compared with the prior art.

Operation of the frequency divider 400 of Figure 4 will now be described in combination with the timing diagram of Figure 5.

Four input signals 402a, 402b, 402c, 402d are provided as input oscillating signals to the frequency divider 400 and are labelled as "Input Phase 0", "Input Phase 1 ", "Input Phase 2" and "Input Phase 3" in Figure 4.

As seen in Figure 5, the four input oscillating signals are equally phase shifted in relation to each other; that is, each input oscillating signal 402 is 90° phase-shifted in relation to its predecessor. As discussed above, it will be appreciated that such an embodiment can provide non-integer division factors of 1.25, 1.5, 1.75, 2.25, 2.5, 2.75, etc. as well as integer division factors.

In this example, only the input oscillating signal 402a with phase zero is provided to the counter 404. The counter 404 has four programmable outputs 416a, 416b, 416c, 416d. The counter 404 comprises a programmable output selection logic module that sets the first counter output 416a high when the counter is at 4; sets the second counter output 416b high when the counter is at 8; sets the third counter output 416c high when the counter is at 12; and sets the fourth output 416d high when the counter is at 16. These are the integer values that are immediately before, but not equal to, the corresponding times at which a rising edge is required in the output signalling 410 (4.25, 8.5, 12.75, 17). The counter output signals 416a, 416b, 416c, 416d are shown in Figure 5.

The first counter output signal 416a is used to generate an output pulse of the frequency divider at an instance in time indicative of 4.25 periods from the point at which the counter 404 started counting. In this example, the output signalling 416a of the counter is provided directly as enable signalling to the gating logic 408. More particularly, the counter output signal 416a is provided as an input to an AND gate 418a of the gating logic 408. In addition, the second input oscillating signal 402b is also provided as an input to the AND gate 418a.

It will be appreciated that the second input oscillating signal 402b is 90° phase shifted relative to the first oscillating signal 402a and therefore has a rising edge at a point in time corresponding to 0.25 x period after the rising edge of the first input oscillating signal 402a.

Generating an enable signal in this way ensures that the output of the AND gate 418a will go high as soon as a rising edge is present on the second oscillating signal 402b after the enable signal 416a has been set. That is, the enable signal is set high at an instance in time before the rising edge of the second input oscillating signal 402b that is intended to be provided as an output pulse, but after the previous rising edge of the second input oscillating signal 402b so as not to provide an output pulse too early.

The output of the AND gate 418a is referenced A 420a, and is also shown in the timing diagram of Figure 5. It can be seen that the output A 420a of the AND gate 418a goes high for a single pulse at an instance in time representative of 4.25 time periods from the start of the first input oscillating signal 402a.

The output A 420a of the AND gate 418a is provided as in input to an OR gate 426. The output of the OR gate 426 is the output signalling 410 of the frequency divider 400. Use of the OR gate 426 enables the output of the AND gate 418a, as well as the output signals of other AND gates 418 (as is described below) to be provided as the output signalling 410.

Operation of a second AND gate 418b is very similar to operation of the first AND gate 418a. The second AND gate 418b receives the second counter output signal 416b as an enable signal, and processes this enable signal along with the third input oscillating signal 402c in order to provide an output pulse B 420b at an instance in time representative of 8.5 time periods after the start of the first oscillating input signal 402a.

A third AND gate 420c is provided in order to generate an output pulse at an instance in time of 12.75 periods from the start of the first input oscillating signal 402a. In this example, the third counter output signal 416c is provided as an input to a delay flip-flop 422a. The clock input to the delay flip-flop 422a is configured to receive the third input oscillating signal 402c. In this way, the output of the delay flip-flop 422a is set high at half a period after the third counter output 416c is set. Effectively, the delay flip-flop 422a provides a ½ period time delay after the third counter output 416c is set. The output signal 424a of the delay flip-flop 422a is the enable signalling for the third AND gate 420c in the gating logic 408. Also provided as an input to the AND gate 420c is the fourth input oscillating signal 402d in order to generate the output pulse C 420c at the desired time.

Operation of a fourth AND gate 418d is similar to the operation of the third AND gate 418c, and is configured to generate an output pulse at an instance in time representative of 17 time periods after the start of the first oscillating signal 402a. In this example, the enable signal 424b is generated using a delay flip-flop in order to ensure that the enable signal is set high before the pulse of the first oscillating signal 402a that is to be provided as the output 410 is received. This may be preferable to using an output of the counter to directly enable the AND gate 418d.

In some embodiments, the counter 404 may introduce a delay such that the enable signal 424b would not be high before the rising edge of the input oscillating signal that is to be passed to the output signal 410 is received. Such embodiments of the invention can remove and/or reduce the delay in passing an output pulse from the input oscillating signal 402a to the output signal 410.

It will be appreciated that the programmable outputs of the counter 404, and how the delay flip flops 422 and logic gates 418, 426 are connected can be configured in any way, or replaced with any components that can perform the same function, in order to provide output signalling that is subject to the required non-integer frequency division factor.

In this realisation, an assumption is made that the clock-to-count delay of the counter 404 is significantly less than ¼ of the clock period (may also be considered as 90° phase), so that the desired timing relation of providing the enable signalling before a rising edge of the input signalling 402 to which it relates can be achieved. It is, of course, possible to change the layout of the pre- alignment block to accommodate a different counter and pre-alignment delay.

In the example illustrated in Figures 4 and 5, the output signalling 410 does not have a 50% duty cycle, but will consist of pulses with a length of ½ the clock period. It will be appreciated that the gating logic 408, or any other embodiment of an output signal selector block, can contain components that are configured to adjust the duty cycle of the output signalling 410 as required. Examples of suitable components can include delay components, timer components, flip-flops, etc.

It will be appreciated that although embodiments of the invention described herein can relate to circuits wherein the output pulse train has accurate rising as well as falling edges, alternative implementations are possible where timing information is contained in the rising or falling edges of the output signalling/pulse train, or may relate to differential logic.

It will be appreciated that the delay from a rising edge of an input phase signal to the rising edge of the output signalling can be identical for all phases, since the direct logic path from all input phase signals to the output can be identical.

In some examples, a feedback counter can be used that has a programmable modulus (M) and has programmable outputs (r, s, t and u). In such examples, any division ratio K/n can be achieved by simply changing the modulus of the counter and re-programming the outputs in an appropriate fashion for a given the number of phases n. For example, for the 4-phase system shown in Figure 4, other possible division ratios are shown in the table below:

| | Modulus | Outputs | | | |
|---|---|---|---|---|---|
| Required division ratio | M | r | s | t | u |
| 17/4 | 17 | 4 | 8 | 12 | 16 |

(continued)

| Required division ratio | Modulus M | Outputs | | | |
|---|---|---|---|---|---|
| | | r | s | t | u |
| 18/4 | 9 | 4 | disabled | 8 | disabled |
| 18/4 (alternative) | 9 | disabled | 4 | disabled | 8 |
| 19/4 | 19 | 14 | 9 | 4 | 18 |
| 20/4 | 5 | disabled | disabled | disabled | 4 |

Advantages/features associated with one or more embodiments of the invention can include:

- The frequency divider can provide direct frequency division by a non-integer factor.
- The frequency divider can easily be made reconfigurable by making the counter reconfigurable.
- The frequency divider can also provide frequency multiplication, by setting a division factor of less than 1.
- The frequency divider can be insensitive or less sensitive to delays and jitter of the counter used, and can therefore have a reduced and/or minimum amount of jitter.
- Although the structure of the frequency divider can require multiple phases at the input frequency to be present, but this may not be considered as a problem as these will often be present in interleaved systems as a default.
- The frequency divider may be used in a PLL that results in a system with improved performance to perform any functionality that is similar to that proposed in the prior art.
- A frequency divider consisting of an n-phase input that drives a counter, the output of which is combined with the input phases to provide direct frequency division by any factor K/n.
- A frequency divider with a configurable counter to allow on-the-fly changes in division ratio.
- A frequency divider used in a fractional-N PLL to provide direct spur-free frequency multiplication by any factor K/n.
- A PLL in combination with a phase-frequency detector that is sensitive only to edges of one type.

## Claims

1. A frequency divider (200; 300; 400) configured to receive a plurality of oscillating signals (202; 302; 402) and generate output signalling (204; 310; 410), the frequency divider comprising:

   an enable signalling generator (206) configured to process the plurality of oscillating signals (202; 302; 402) and generate enable signalling (210; 314) representative of which of the oscillating signals (202; 302; 402) is to be used to derive the output signalling (204; 310; 410);
   an output signal selector (208; 308; 408) configured to process one or more of the oscillating signals (202; 302; 402) and the enable signalling (210; 314) such that an oscillating signal (202; 302; 402) is provided as the output signalling (204; 310; 410) of the frequency divider in accordance with the enable signalling (210; 314).

2. The frequency divider of claim 1, wherein the oscillating signal (202; 302; 402) that is to be used to derive the output signalling (204; 310; 410) comprises a rising edge that is to be a rising edge in the output signalling (204; 310; 410), and the enable signalling is configured to cause the output signal selector to set the oscillating signal (202; 302; 402) as the output signalling (204; 310; 410) at a point in time before the rising edge of the oscillating signal (202; 302; 402).

3. The frequency divider of claim 2, wherein the point in time is after a previous rising edge of the oscillating signal (202; 302; 402).

4. The frequency divider of claim 2, wherein the point in time is after a preceding trailing edge of the oscillating signal (202; 302; 402).

5. The frequency divider of any preceding claim, wherein the enable signalling generator is configured to set the enable signalling before the occurrence of the portion of the corresponding oscillating input signal that is to be provided as the output signalling.

**6.** The frequency divider of any preceding claim, wherein the enable signalling generator comprises a counter (304; 404) configured to process one or more of the plurality of oscillating signals (302; 402) and generate one or more counter output signals (312; 416) representative of when one or more of the plurality of oscillating signals (302; 402) reaches a predetermined count value; and the enable signalling generator is further configured to derive the enable signalling (210; 314) from the one or more counter output signals (312; 416).

**7.** The frequency divider of claim 6, wherein the enable signalling (314) comprises one or more of the counter output signals (312; 416).

**8.** The frequency divider of claim 6 or claim 7, wherein the counter (304; 404) is a programmable counter.

**9.** The frequency divider of any one of claims 6 to 8, wherein the enable signalling generator further comprises a pre-alignment block of components comprising one or more delay components (422) configured to apply a time delay to one or more of the counter output signals in accordance with one or more of the oscillating signals in order to generate the enable signalling.

**10.** The frequency divider of any preceding claim, wherein the output signal selector (208; 308; 408) comprises one or more logic gates that are configured to pass an input oscillating signal (302; 402) to the output signalling when the enable signalling associated with the input oscillating signal (302; 402) is set.

**11.** A phase locked loop comprising the frequency divider of any preceding claim.

**12.** The phase locked loop of claim 11, wherein the phase locked loop comprises an oscillator configured to generate the plurality of input oscillating signals (302; 402).

**13.** A device comprising the frequency divider of any one of claims 1 to 10 or the phase locked loop of claim 11 or claim 12.

**14.** A method of operating a frequency divider comprising:

receiving a plurality of oscillating signals (202; 302; 402);
processing the plurality of oscillating signals (202; 302; 402) to generate enable signalling (210; 314) representative of which of the oscillating signals (202; 302; 402) is to be used to derive the output signalling; and
processing one or more of the oscillating signals (202; 302; 402) and the enable signalling (210; 314) such that an oscillating signal (202; 302; 402) is provided as the output signalling (204; 310; 410) of the frequency divider in accordance with the enable signalling (210; 314).

**15.** A computer program, which when run on a computer, causes the computer to configure the frequency divider of any one of claims 1 to 10, the phase locked loop of claim 11 or claim 12, or the device of claim 13.

# Figure 1

100

Fref → Phase Detector → Loop Filter → Voltage Controlled Oscillator (VCO) → Four=Fref*N

Feedback divider (/N)

Figure 1: Integer-N PLL

# Figure 2

208

204

Oscillating signals

202

Output signal selector

Output

Enable signalling generator

206

210

200

## Figure 3

## Figure 4

# Figure 5

EP 2 288 031 A1

Europäisches
Patentamt

European
Patent Office

Office européen
des brevets

## EUROPEAN SEARCH REPORT

Application Number

EP 09 25 1896

| | DOCUMENTS CONSIDERED TO BE RELEVANT | | | |
|---|---|---|---|---|
| Category | Citation of document with indication, where appropriate, of relevant passages | Relevant to claim | CLASSIFICATION OF THE APPLICATION (IPC) | |
| X | US 6 157 694 A (LARSSON PATRIK [US]) 5 December 2000 (2000-12-05) * abstract * * figures 1,2,3,5 * * column 1, line 5 - line 13 * * column 1, line 43 - line 55 * * column 4, line 25 - line 33 * * column 4, line 13 - line 23 * * column 7, line 43 - line 60 * ----- | 1-15 | INV. H03K23/68 G06F7/62 | |
| X A | US 6 114 914 A (MAR MONTE F [US]) 5 September 2000 (2000-09-05) * column 3, line 50 - column 4, line 35; figures 4,5 * ----- | 1,6-15 2 | | |
| A | US 2003/198311 A1 (SONG BANG-SUP [US] ET AL) 23 October 2003 (2003-10-23) * abstract; figures 1,4 * ----- | 1,6-8, 10-15 | | |
| | | | TECHNICAL FIELDS SEARCHED (IPC) | |
| | | | H03K G06F | |

The present search report has been drawn up for all claims

| Place of search | Date of completion of the search | Examiner |
|---|---|---|
| Munich | 3 December 2009 | Mesic, Maté |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 25 1896

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2009

| Patent document cited in search report | | Publication date | Patent family member(s) | Publication date |
|---|---|---|---|---|
| US 6157694 | A | 05-12-2000 | NONE | |
| US 6114914 | A | 05-09-2000 | NONE | |
| US 2003198311 | A1 | 23-10-2003 | NONE | |

EPO FORM P0459

For more details about this annex : see Official Journal of the European Patent Office, No. 12/82

**EP 2 288 031 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020027459 A, (Fallahi
- US 6526374 B
- US 6542013 B